Europäisches Patentamt

(19) European Patent Office

Office européen des brevets

(11) Veröffentlichungsnummer: **0 006 467**
A2

(12) **EUROPÄISCHE PATENTANMELDUNG**

(21) Anmeldenummer: 79101693.4

(22) Anmeldetag: 01.06.79

(51) Int. Cl.³: **G 11 C 19/28,** G 06 F 7/00

(30) Priorität: 30.06.78 US 920923

(43) Veröffentlichungstag der Anmeldung: 09.01.80
Patentblatt 80/1

(84) Benannte Vertragsstaaten: DE FR GB

(71) Anmelder: **International Business Machines
Corporation, Armonk, N.Y. 10504 (US)**

(72) Erfinder: **Aichelmann, Jr., Frederick John, RD. No. 7,
Taconic Drive, Hopewell Jct., NY 12533 (US)**

(74) Vertreter: **Teufel, Fritz, Dipl.-Phys., Schönaicher
Strasse 220, D-7030 Böblingen (DE)**

(54) **Ladungstransportspeicher mit Verschränkung.**

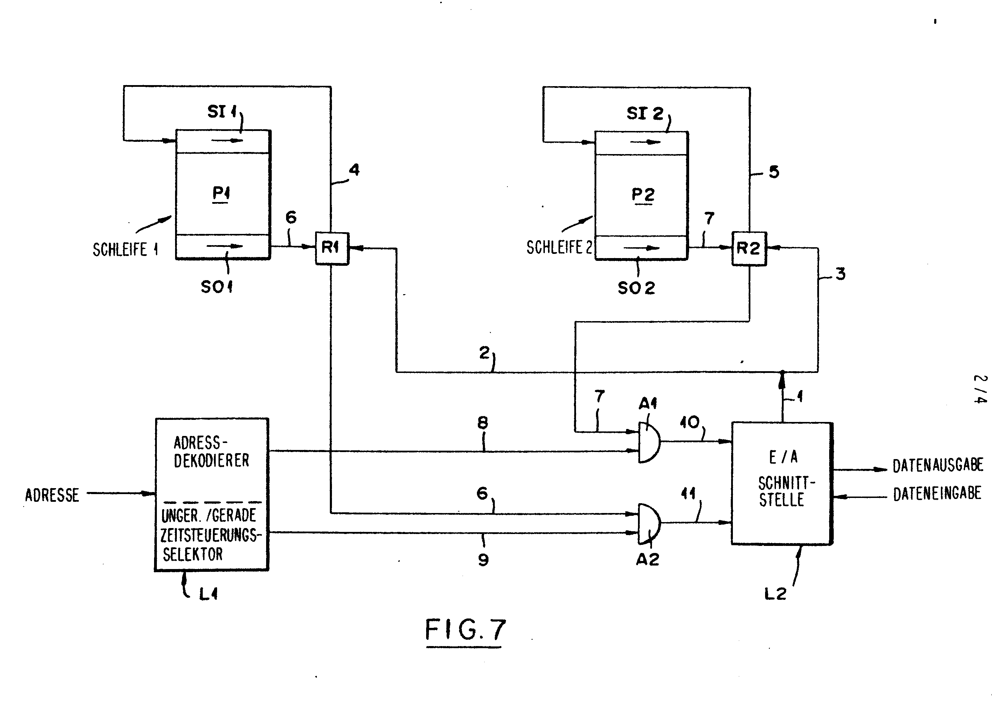

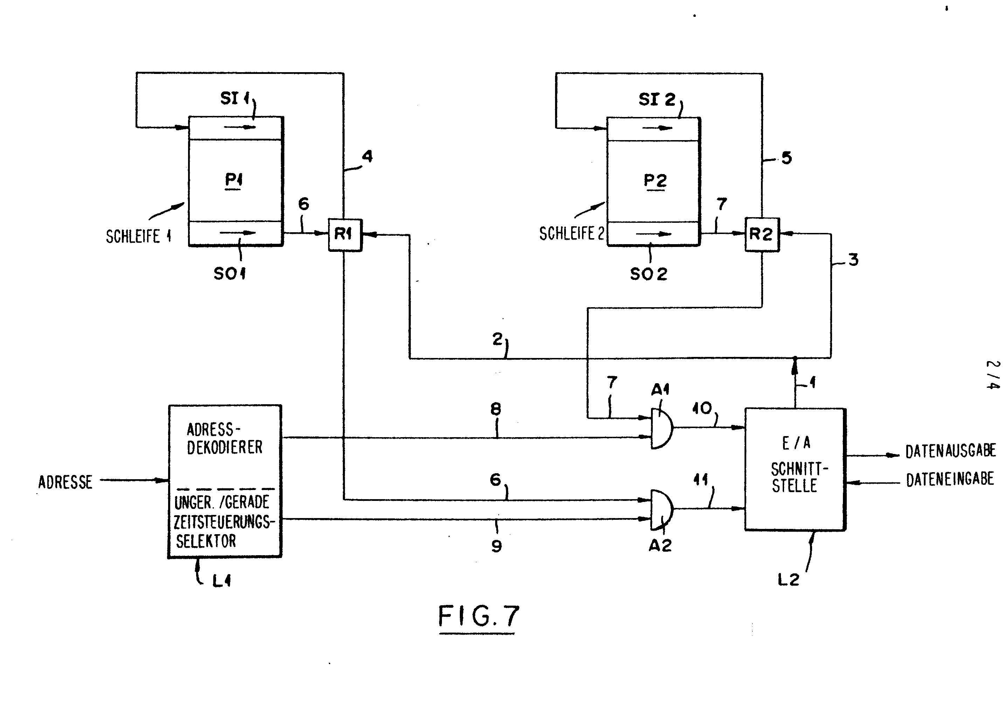

(57)  Ein Ladungstransportspeicher (CCD-Speicher) mit verschränkter Speicherung enthält mindestens ein Paar CCD-
Schleifen (SCHLEIFE 1, SCHLEIFE 2; Fig. 7) vom Typ se-
riell-parallel-seriell (SPS-Schleife). Die zu speichernden
Datenelemente, z. B. Bytes, werden durch geeignete Zeitsteuersignale (Zeitsteuerselektor L1) bitweise aufgespalten und auf die beiden SPS-Schleifen verteilt; die ungeradzahligen Bits A1, A3, A5, A7 eines ersten Bytes A werden
mit den geradzahligen Bits B2, B4, B6, B8 eines zweiten
Bytes B in eine Zeile des Parallelabschnitts P1 in der ersten
SPS-Schleife gegeben und entsprechend die geradzahligen
Bits des ersten Bytes A zusammen mit den ungeradzahligen
Bits des zweiten Bytes B in den Parallelabschnitt P2 der
zweiten SPS-Schleife. Am Ende der Parallelabschnitte werden die so verschränkten Bits beider Datenelemente zusammen in das Ausgangsschieberegister SO der SPS-
Schleifen gegeben und von dort mit Hilfe geeignet gesteuerter Torschaltungen (A1, A2) in der ursprünglichen Bit-
Reihenfolge der Bytes ausgegeben.

## Ladungstransportspeicher mit Verschränkung

Die Erfindung betrifft einen Ladungstransportspeicher nach dem Oberbegriff des Hauptanspruchs.

Ladungstransportspeicher, sogenannte CCD-Speicher, sind für Anwendungen in Datenverarbeitungsanlagen und zur Signalverarbeitung in Übertragungssystemen bekannt. Das grundlegende Prinzip dieser Anordnung, Ladungsverschiebungen in Halbleitern als Datenspeicher zu verwenden, ist beispielsweise aus folgenden Veröffentlichungen bekannt: Boyle, W.S. und Smith, G.E., "Charge Coupled Semiconductor Devices", Bell Sys. Tech. J. (April 1970), Seiten 587-593; Boyle, W.S. und Smith, G.E., US-Patent Nr. 3 858 232; Smith, G.E., US-Patent Nr. 3 761 744; eine besondere Ausgestaltung dieser Speicher in Form sogenannter Seriell-Parallel-Seriell (SPS)-Anordnungen wird beschrieben in Weimer, P.K., US-Patent 3 763 480; Tompsett, M.F., "Charge Transfer Devices", J. Vac. Sci. Technol., Bd. 9, Nr. 4, (Juli-August 1972), Seiten 1166-1181, Collins, D.R. et al "CCD Memory Options" IEEE International Solid-State Cicuits Conference, (Februar 1973), Seiten 136-137, 210.

Bei der Seriell-Parallel-Seriell-Konfiguration wird ein Strom von Datenbits in ein serielles Eingabe-Schieberegister gegeben und von dort parallel in einen parallel ausgestalteten Teil des Speichers übertragen. Die Daten können dann parallel durch diesen Abschnitt verschoben werden und schließlich, ebenfalls parallel, in ein seriell arbeitendes Ausgabe-Schieberegister, von wo sie als serieller Bitstrom austreten.

Die Speicherdichte dieser SPS-Konfiguration war beschränkt, da Ladungstransportspeicher sowohl für die Übertragung als auch die Speicherung besondere Plätze benötigen. In einem mit zwei Phasen arbeitenden seriellen Schieberegister wird

FI 978 006

zur Speicherung eines Informationsbits also nicht nur ein Speicherplatz benötigt, sondern auch noch ein Übertragungsplatz mit der Folge, daß die Bits zu jedem Zeitpunkt nur die Hälfte der zur Verfügung stehenden Plätze belegen. So können beispielsweise in einem zweiphasigen seriellen Ladungstransportspeicher mit acht Plätzen nur vier Bits gespeichert werden. Der parallel aufgebaute Abschnitt des Speichers wies ähnliche Beschränkungen auf, da die Kanalbreite notwendigerweise doppelt so breit war wie ein einzelner Platz in den seriellen Abschnitten, so daß auch in dem Parallelabschnitt nur die Hälfte der potentiell verfügbaren Speicherplätze ausgenutzt werden konnte.

Die Bitdichte der Speicherung konnte dann durch die sogenannte verschränkte Ausführung der SPS-Konfiguration beträchtlich verbessert werden. Bei der verschränkten Ausführung des obigen Beispiels mit acht Plätzen und zweiphasiger Betriebsweise können alle acht seriellen Bits parallel durch den Parallelabschnitt durchgeschoben werden, wodurch zumindest theoretisch die Anzahl der im Parallelabschnitt speicherbaren Bits verdoppelt wird. Ausführungsformen der verschränkten Konfigurationen sind beispielsweise in folgenden Veröffentlichungen beschrieben: Elmer, B.R, Tchon, W.E., Denboer, A.J., Frommer, R., Kohyama, S. und Hirabayashi, K. "Fault Tolerant 92160-Bit Multiphase CCD Memory", IEEE International Solid-State Circuits Conference (Februar 1977), Seiten 116-117; Elmer, B.R., US-Patent 4 024 509; Elmer B.R. und Tchon, W.E., US-Patent 3 986 179; Carnes, J.E. und Kosonocky, W.F., "Charge-Coupled Devices and Applications", Solid State Technology (April 1974), Seiten 67-77; Kosonocky, W.F. und Sauer, D.J., US-Patent 3 967 254; Erb, D.M., US-Patent 3 913 077.

Die verschränkte Konfiguration des Standes der Technik wies jedoch den schwerwiegenden Nachteil auf, daß die Datenbits

FI 978 006

bei der Übergabe von seriellen Eingaberegister in die erste
Reihe des Parallelabschnitts durchmischt wurden; d.h. die
Datenbits erschienen in einer Reihenfolge, die verschieden
war von der ursprünglichen Reihenfolge des Eingabebitstroms.
Daher waren zusätzliche Schaltkreise erforderlich, um die
Bits wieder zu entmischen und die ursprüngliche Reihenfolge
wiederherzustellen. Diese zusätzlichen Schaltkreise trugen
maßgeblich zur Komplexität und den Kosten von verschränkten
Speichereinrichtungen bei.

Die vorliegende Erfindung stellt sich daher die Aufgabe,
einen Ladungstransportspeicher mit verschränkter Seriell-
Parallel-Seriell-Konfiguration anzugeben, bei dem die gespeicherten Datenbits bei der Ausgabe in der gleichen Reihenfolge erscheinen wie bei der Eingabe.

Diese Aufgabe wird durch die im Hauptanspruch gekennzeichnete
Erfindung gelöst; Ausgestaltungen der Erfindung sind in den
Unteransprüchen gekennzeichnet.

In einer Ausführungsform werden dazu auf neuartige Weise
zwei SPS-Schleifen miteinander kombiniert. Die ungeradzahligen Bits eines ersten Datenelements (z. B. Byte) im Eingabebitstrom werden jeweils abwechselnd mit den geraden Bits
eines weiteren Datenelements des Eingabestroms verschränkt
und diese verschränkten Bits in der ersten SPS-Schleife
gespeichert. Auf ähnliche Weise werden die geradzahligen
Bits des ersten Datenelements jeweils mit den ungeradzahligen Bits des zweiten Datenelements verschränkt und zusammen
in der zweiten SPS-Schleife gespeichert. Durch entsprechend
gewählte Taktsignale können die verschränkten Bits abwechselnd aus den SPS-Schleifen in der gleichen Reihenfolge wie
im ursprünglichen Eingabebitstrom ausgelesen werden.

Ein Ausführungsbeispiel der Erfindung wird nun anhand von
Zeichnungen näher erläutert. Es zeigen:

FI 978 006

Fign. 1 bis 6  das Problem der durchmischten Datenbits bei verschränkten Seriell-Parallel-Seriell-Konfigurationen im Stand der Technik;

Fig. 7  ein Paar von SPS-Schleifen mit zugehöriger Steuerlogik nach einem Ausführungsbeispiel der vorliegenden Erfindung;

Fig. 8  Einzelheiten der Steuerlogik von Fig. 7;

Fig. 9  die Reihenfolge der Datenbits in dem seriellen Eingabeabschnitt der ersten Schleife, wo abwechselnd die ungeradzahligen Bits eines ersten Datenelements mit den geraden Bits eines zweiten Datenelements verschränkt werden;

Fig. 10  entsprechend Fig. 9 die Bitreihenfolge des seriellen Eingabeabschnitts der zweiten Schleife, wo abwechselnd die geradzahligen Bits eines ersten Datenelements mit den ungeradzahligen Bits des zweiten Datenelements verschränkt werden;

Fig. 11  die ursprüngliche und die abgegebene Reihenfolge der Datenbits eines ersten Datenelements;

Fig. 12  die ursprüngliche und die abgegebene Reihenfolge der Datenbits eines zweiten Datenelements, das mit dem ersten Datenelement in den beiden Schleifen verschränkt gespeichert wurde.

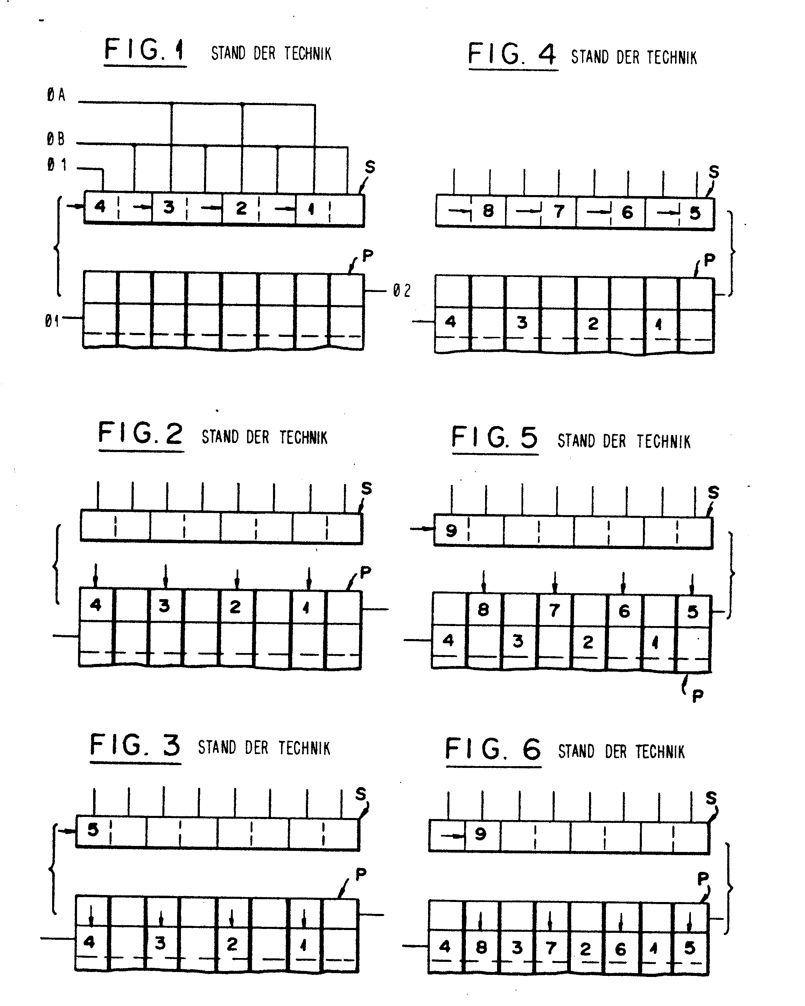

In den Fign. 1 bis 6 ist die Durchmischung der Datenbits dargestellt, die bei konventionellen verschränkten Seriell-

FI 978 006

bei der Übergabe von seriellen Eingaberegister in die erste Reihe des Parallelabschnitts durchmischt wurden; d.h. die Datenbits erschienen in einer Reihenfolge, die verschieden war von der ursprünglichen Reihenfolge des Eingabebitstroms. Daher waren zusätzliche Schaltkreise erforderlich, um die Bits wieder zu entmischen und die ursprüngliche Reihenfolge wiederherzustellen. Diese zusätzlichen Schaltkreise trugen maßgeblich zur Komplexität und den Kosten von verschränkten Speichereinrichtungen bei.

Die vorliegende Erfindung stellt sich daher die Aufgabe, einen Ladungstransportspeicher mit verschränkter Seriell-Parallel-Seriell-Konfiguration anzugeben, bei dem die gespeicherten Datenbits bei der Ausgabe in der gleichen Reihenfolge erscheinen wie bei der Eingabe.

Diese Aufgabe wird durch die im Hauptanspruch gekennzeichnete Erfindung gelöst; Ausgestaltungen der Erfindung sind in den Unteransprüchen gekennzeichnet.

In einer Ausführungsform werden dazu auf neuartige Weise zwei SPS-Schleifen miteinander kombiniert. Die ungeradzahligen Bits eines ersten Datenelements (z. B. Byte) im Eingabebitstrom werden jeweils abwechselnd mit den geraden Bits eines weiteren Datenelements des Eingabestroms verschränkt und diese verschränkten Bits in der ersten SPS-Schleife gespeichert. Auf ähnliche Weise werden die geradzahligen Bits des ersten Datenelements jeweils mit den ungeradzahligen Bits des zweiten Datenelements verschränkt und zusammen in der zweiten SPS-Schleife gespeichert. Durch entsprechend gewählte Taktsignale können die verschränkten Bits abwechselnd aus den SPS-Schleifen in der gleichen Reihenfolge wie im ursprünglichen Eingabebitstrom ausgelesen werden.

Ein Ausführungsbeispiel der Erfindung wird nun anhand von Zeichnungen näher erläutert. Es zeigen:

FI 978 006

Fign. 1 bis 6    das Problem der durchmischten Datenbits bei verschränkten Seriell-Parallel-Seriell-Konfigurationen im Stand der Technik;

Fig. 7    ein Paar von SPS-Schleifen mit zugehöriger Steuerlogik nach einem Ausführungsbeispiel der vorliegenden Erfindung;

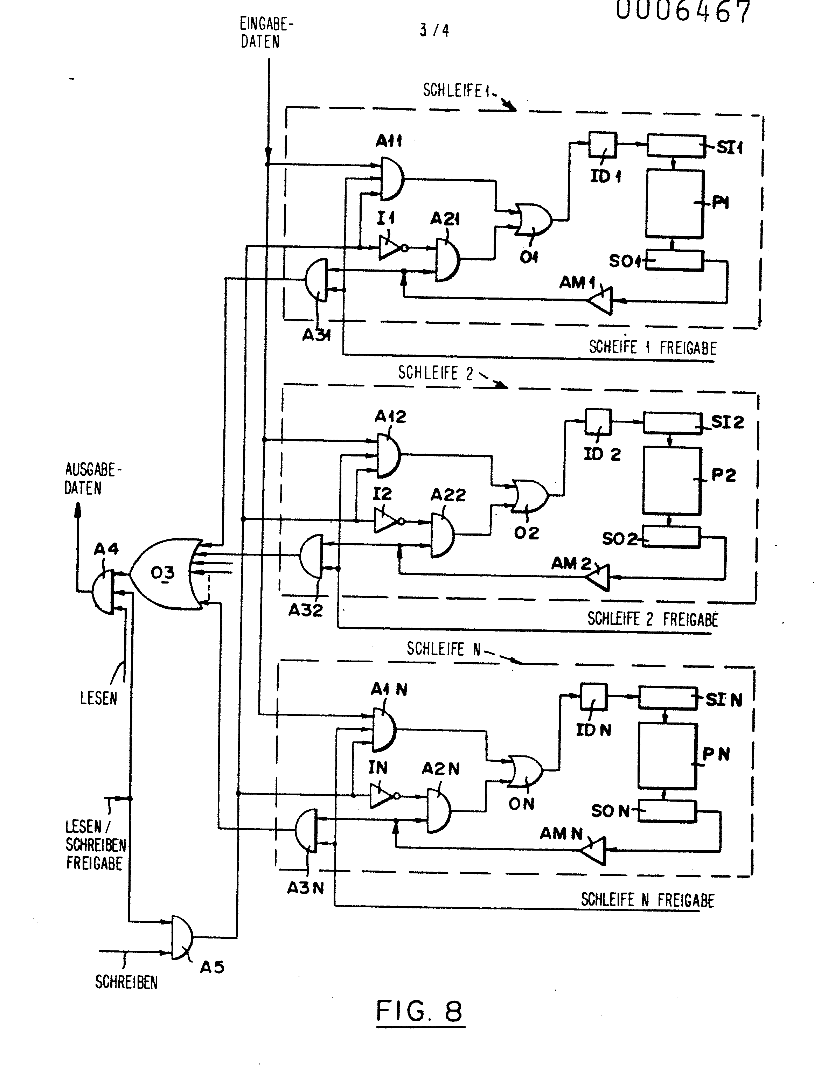

Fig. 8    Einzelheiten der Steuerlogik von Fig. 7;

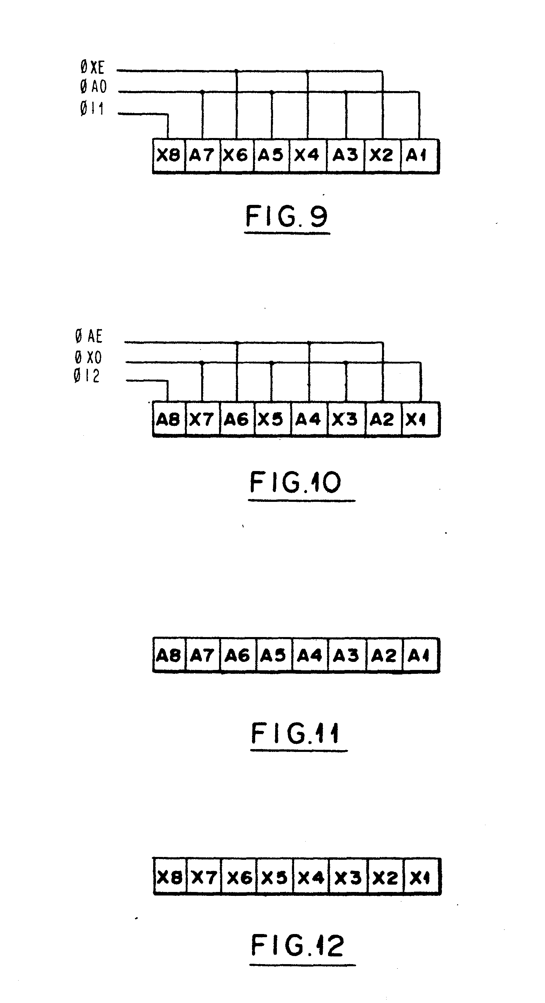

Fig. 9    die Reihenfolge der Datenbits in dem seriellen Eingabeabschnitt der ersten Schleife, wo abwechselnd die ungeradzahligen Bits eines ersten Datenelements mit den geraden Bits eines zweiten Datenelements verschränkt werden;

Fig. 10    entsprechend Fig. 9 die Bitreihenfolge des seriellen Eingabeabschnitts der zweiten Schleife, wo abwechselnd die geradzahligen Bits eines ersten Datenelements mit den ungeradzahligen Bits des zweiten Datenelements verschränkt werden;

Fig. 11    die ursprüngliche und die abgegebene Reihenfolge der Datenbits eines ersten Datenelements;

Fig. 12    die ursprüngliche und die abgegebene Reihenfolge der Datenbits eines zweiten Datenelements, das mit dem ersten Datenelement in den beiden Schleifen verschränkt gespeichert wurde.

In den Fign. 1 bis 6 ist die Durchmischung der Datenbits dargestellt, die bei konventionellen verschränkten Seriell-

FI 978 006

Parallel-Seriell-Konfigurationen im Stand der Technik auftritt und durch die vorliegende Erfindung vermieden werden
soll. In jeder dieser Figuren ist der Abschnitt des seriellen
Eingaberegisters mit S bezeichnet, der Parallelabschnitt
des Speichers mit P. Nur die ersten beiden Reihen (Zeilen)
des Parallelabschnitts P sind dargestellt. Der Einfachheit
und Klarheit halber ist der serielle Eingabeabschnitt S mit
nur acht Speicherplätzen für Ladungspakete gezeichnet, der
Parallelabschnitt mit nur acht Spalten, die jeweils einem
bestimmten Platz des seriellen Abschnitts entsprechen. In
der praktischen Ausführung weisen beide Abschnitte sehr viel
mehr Plätze bzw. Spalten auf.

In Fig. 1 sind die ersten vier Datenbits eines seriell eingegebenen Bitstroms mit 1 bis 4 bezeichnet; sie werden seriell in den seriellen Eingabeabschnitt S eingegeben. Jedes
Bit wird mit Hilfe eines Eingabetaktsignals $\phi 1$ in einen
ersten Speicherplatz gegeben. Die serielle Übertragung der
Ladungspakete, die den jeweilige Bits entsprechen, erfolgt
mit üblichen Taktsignalen $\phi A$ und $\phi B$. Die Taktsignale $\phi A$,
$\phi B$, $\phi 1$, $\phi 1'$, $\phi 2'$, die in Fig. 1 dargestellt sind, liegen
auch in den Figuren 2 bis 6 an, wo sie jedoch nicht explizit dargestellt sind.

Das Taktsignal $\phi 2'$ in Fig. 2 bewirkt, daß die vier Ladungspakete, die den ersten vier Datenbits 1, 2, 3, 4 entsprechen,
in simultaner Weise parallel in die erste Reihe (Zeile)
des Parallelabschnitts P übertragen werden. Man sieht, daß
die den ersten vier Datenbits entsprechenden Ladungspakete
jeweils abwechselnde Ladungsspeicherplätze in der ersten
Reihe des Parallelabschnitts P belegen.

In Fig. 3 sind die ersten vier Datenbits 1, 2, 3, 4 durch
das Taktsignale $\phi 1'$ in die zweite Reihe des Parallelabschnitts
P übertragen worden, während das dem fünften Datenbit ent-

FI 978 006

sprechende und mit 5 bezeichnete Ladungspaket in den ersten Ladungsspeicherplatz des seriellen Eingabeabschnitts S gebracht wurde.

In Fig. 4 wurde die zweite aus den vier Bits 5, 6, 7 und 8 bestehende Gruppe mit Hilfe der Taktsignale $\phi A$ und $\phi B$ in den seriellen Eingabeabschnitt S gegeben. Man sieht, daß diese Bits 5, 6, 7 und 8 nun die jeweils anderen Ladungsspeicherplätze belegen, d.h. solche, die von der ersten Bitgruppe 1, 2, 3, 4 nicht belegt wurden.

In Fig. 5 wurde mit dem Taktsignal $\phi 2'$ die zweite Gruppe aus vier Datenbits 5, 6, 7 und 8 aus dem seriellen Eingabeabschnitt S in die erste Reihe des Parallelabschnitts P übertragen und gleichzeitig das neunte Datenbit in den ersten Ladungsspeicherplatz des seriellen Abschnitts S. In Fig. 6 hat Taktsignal $\phi 1'$ die zweite Gruppe von Datenbits 5, 6, 7 und 8 aus der ersten Reihe des Parallelabschnitts P in die zweite Reihe übertragen.

Man sieht jetzt, daß die erste Gruppe von Datenbits 1, 2, 3, 4 und die zweite Gruppe von Datenbits 5, 6, 7 und 8 nun in der zweiten Reihe des Parallelabschnitts P verschränkt sind und damit die Bitreihenfolge bezüglich der ursprünglichen Reihenfolge durchmischt wurde. Beim Vorgehen nach dem Stand der Technik wurde diese durchmischte Bitreihenfolge 5, 1, 6, 2, 7, 3, 8, 4 parallel von Reihe zu Reihe des Parallelabschnitts P übertragen und dann bei der Ausgabe aus der letzten Reihe dieses Abschnitts entmischt. Zu diesem Entmischen wurden zusätzliche logische Schaltkreise verwendet, die komplex und teuer waren.

In Fig. 7 ist eine bevorzugte Ausführungsform der Erfindung dargestellt. Eine erste Seriell-Parallel-Seriell-Konfiguration SCHLEIFE 1 enthält einen seriellen Eingabeabschnitt SI1, einen Parallelabschnitt P1, einen seriellen Ausgabeabschnitt

FI 978 006.

SO1 und einen Regenerator R1. Eine Leitung 4 verläuft vom Regenerator R1 zum Eingang des seriellen Eingabeabschnitts SI1. Eine Leitung 6 verläuft vom Ausgang des seriellen Ausgabeabschnitts SO1 zum Regenerator R1.

Eine zweite SPS-Konfiguration SCHLEIFE 2 umfaßt einen seriellen Eingabeabschnitt SI2, einen Parallelabschnitt P2, einen seriellen Ausgabeabschnitt SO2 und einen Regenerator R2. Eine Leitung 5 verläuft vom Regenerator R2 zum Eingang des seriellen Eingabeabschnitts SI2. Eine Leitung 7 verläuft vom Ausgang des seriellen Ausgabeabschnitts SO2 zum Regenerator R2.

Eine konventionelle Eingabe/Ausgabeschnittstelle L2 mit einem Anschluß DATENEINGABE und einem Anschluß DATENAUSGABE vermittelt die Dateneingabe und die Datenausgabe zu der Konfiguration. Die Leitungen 1, 2 verlaufen von der Eingabe/Ausgabeschnittstelle L2 zum Regenerator R1, die Leitungen 1, 3 in ähnlicher Weise zum Regenerator R2.

Die Logikschaltungen zur Adreßdecodierung, zur Zeitsteuerung der SCHLEIFEN und zur Auswahl der abwechselnden ungeradzahligen und geradzahligen Bits der jeweiligen Datenelemente sind symbolisch durch den Block L1 dargestellt, der einen Adreßeingang für die Adreßselektion besitzt. Eine Leitung 8 verläuft vom Adreßdecodierer L1 zu einem ersten UND-Glied A1, eine zweite Leitung 9 zu einem zweiten UND-Glied A2. Der zweite Eingang des UND-Glieds A1 ist mit einer Leitung 7 vom Regenerator R2 verbunden, der zweite Eingang des UND-Glieds A2 mit einer Leitung 6 vom Regenerator R1.

In Fig. 7 dient die Darstellung der logischen Schaltkreise für die Datenregeneration, die Adreßdecodierung, die Selektion der SCHLEIFEN-Bits und die Zeitsteuerung als getrennte Blöcke R1, R2, L1, L2 nur zur Vereinfachung der Erläuterung; bei der praktischen Ausführung können diese

FI 978 006

Schaltkreise eng miteinander zusammengepackt werden. Die Schaltungen sind außerdem konventionell und im Stand der Technik bekannt. Zur Erläuterung einer der vielen Formen, die bei der praktischen Ausführung dieser Schaltungen in Frage kommen, zeigt Fig. 8 eine typische konventionelle Anordnung zur Steuerung der Eingabe-, Ausgabe-, Lese- und Schreib-Vorgänge von Seriell-Parallel-Seriell-Konfigurationen.

Der einfachen Darstellung halber zeigt Fig. 8 nur drei SPS-Konfigurationen, die mit SCHLEIFE 1, SCHLEIFE 2 bzw. SCHLEIFE N bezeichnet sind. Diese drei Schleifen sind untereinander identisch und tragen dieselben Bezugszeichen, unterschieden durch den Suffix "1" für die SCHLEIFE 1, den Suffix "2" für die SCHLEIFE 2 und den Suffix "N" für die SCHLEIFE N. Es genügt daher, nur SCHLEIFE 1 im einzelnen zu beschreiben.

"SCHLEIFE 1" umfaßt einen Abschnitt SI1 eines seriellen Eingaberegisters, einen Parallelabschnitt P1 und einen Abschnitt SO1 eines seriellen Ausgaberegisters. Zu SCHLEIFE 1 gehören logische Schaltglieder, darunter drei UND-Glieder, A11, A21, A31, ein ODER-Glied O1, einen Inverter I1, ein Eingabeelement ID1 und einen Verstärker AM1. Jedes dieser logischen Elemente ist in konventioneller Weise aufgebaut.

Die Eingangsdaten werden an den in der Zeichnung angegebenen Stellen zugeführt und an einen Eingang jedes der UND-Glieder A11, A12, A1N angelegt. Ein zweiter Eingang des UND-Glieds A11 empfängt ein Freigabesignal mit der Bezeichnung SCHLEIFE 1 FREIGABE. In ähnlicher Weise ist jeder zweite Eingang der UND-Glieder A12 und A1N mit entsprechend bezeichneten Freigabesignalen beaufschlagt. Ein dritter Eingang jedes der UND-Glieder A11, A12, A1N empfängt das Ausgangssignal des UND-Glieds A5. Einer der Eingänge des letztgenannten Gliedes empfängt das Signal SCHREIBEN, der andere Eingang das Signal LESEN/SCHREIBEN FREIGABE.

FI 978 006

Das Ausgangssignal des UND-Gliedes A5 wird außerdem an die Eingänge der Inverter I1, I2 bzw. IN gelegt. Die Ausgangssignale dieser Inverter werden den UND-Gliedern A21, A22 bzw. A2N zugeführt. Die Ausgangssignale von diesen gelangen an die Eingänge der ODER-Glieder O1, O2, ON. Die Ausgangssignale dieser ODER-Glieder ihrerseits werden den Eingangsschaltungen ID1, ID2, IDN zugeführt.

Die Ausgangssignale der Abschnitte SO1, SO2, SON der seriellen Ausgaberegister werden den Eingängen der Verstärker AM1, AM2 bzw. AMN zugeführt. Die Ausgangssignale dieser Verstärker gelangen zu den UND-Gliedern A21, A22 bzw. A2N. Die Ausgangssignale der Verstärker AM1, AM2, AMN werden außerdem den Eingängen der UND-Glieder A31, A32, A3N zugeführt. Die Signale SCHLEIFE FREIGABE werden ebenfalls an diese letztgenannten Glieder geliefert. Die Ausgangssignale der UND-Glieder A31, A32, A33 werden den Eingängen des ODER-Gliedes O3 zugeführt, dessen Ausgang mit einem der Eingänge des UND-Gliedes A4 verbunden ist. Der zweite Eingang dieses UND-Gliedes empfängt das Signal LESEN/SCHREIBEN FREIGABE, der dritte Eingang das Signal LESEN. Das Ausgangssignal des UND-Gliedes A4 liefert das Signal AUSGABE DATEN.

Betriebsweise

Die Arbeitsweise der bisher beschriebenen Vorrichtung wird nun anhand der Figuren 7 und 9 bis 12 erläutert. Der serielle Strom von Datenbits wird dem Anschluß DATENEINGABE der E/A-SCHNITTSTELLE L2 zugeführt. Der einfachen Darstellung halber wird angenommen, daß dieser serielle Eingabestrom eine Folge von Datenelementen ist, die jeweils aus einer Kette von acht Bits bestehen. Die beiden Schleifenanordnungen SCHLEIFE 1 und SCHLEIFE 2 in Fig. 7 dienen zur Speicherung dieser beiden Datenelemente. Diese Datenelemente liegen im allgemeinen innerhalb des Eingabedatenbitstroms nicht

FI 978 006

0006467

nebeneinander. Die Bits des ersten Elements werden mit A1 bis A8 bezeichnet, die Bits des zweiten Elements mit X1 bis X8.

Durch an die Steuerlogik angelegte Taktsignale werden die ungeradzahligen Bits A1, A3, A5, A7 von der E/A-SCHNITTSTELLE L2 auf den Leitungen 1, 2 an den Regenerator R1 und von dort über Leitung 4 an den seriellen Eingabeabschnitt SI1 der SCHLEIFE 1 gegeben. Auf ähnliche Weise werden die geradzahligen Bits X2, X4, X6, X8 des Datenbitstroms an den seriellen Eingabeabschnitt·SI1 von SCHLEIFE 1 gegeben und in dem genannten seriellen Eingabeabschnitt mit den vorher übertragenen ungeradzahligen Bits A1, A3, A5, A7 des ersten Datenelements verschränkt, so daß im seriellen Eingabeabschnitt SI1 der ersten Schleife die in Fig. 9 dargestellte Bitreihenfolge entsteht. Diese Reihe von Bits wird dann in bekannter Weise parallel an den Parallelabschnitt P1 der SCHLEIFE 1 abgegeben.

Die geradzahligen Bits A2, A4, A6, A8 des ersten Datenelements im seriellen Datenbitstrom werden mit geeigneten Taktsignalen von der E/A-SCHNITTSTELLE L2 über Leitungen 1, 3, den Regenerator R2 und die Leitung 5 an den seriellen Eingabeabschnitt SI2 der SCHLEIFE 2 gegeben. Auf ähnliche Weise gelangen die ungeradzahligen Bits X1, X3, X5, X7 des zweiten Datenelements zum seriellen Eingabeabschnitt SI2 der SCHLEIFE 2 und werden dort mit den früher übertragenen geradzahligen Bits A2, A4, A6, A8 verschränkt, so daß sich im seriellen Eingabeabschnitt SI2 die in Fig. 10 dargestellte Bitreihenfolge ergibt. Diese Reihe von Bits wird dann auf übliche Weise parallel an den Parallelabschnitt P2 der SCHLEIFE 2 abgegeben.

Die in Fig. 9 dargestellte Bitreihe erreicht schließlich den Abschnitt SO1 im seriellen Ausgaberegister der SCHLEIFE

FI 978 006

1 und die in Fig. 10 dargestellte Bitreihe schließlich den Abschnitt SO2 des seriellen Ausgaberegisters in SCHLEIFE 2. Die in Fig. 9 dargestellte Reihe kann dann entweder durch Regenerator R1 regeneriert werden und über Leitung 4 wieder an den Eingang des seriellen Eingabeabschnitts SI1 gelangen, oder aber sie kann über Leitung 6 und UND-Glied A2 an die E/A-SCHNITTSTELLE L2 zur Ausgabe am Anschluß DATENAUSGABE übertragen werden. In ähnlicher Weise erreicht die in Fig. 10 dargestellte Reihe von Datenbits schließlich den Abschnitt SO2 des seriellen Ausgaberegisters und kann dann entweder mit Regenerator R2 regeneriert und über Leitung 5 an den Abschnitt SI2 des seriellen Eingaberegisters zurückgeführt werden; als Alternative steht aber auch hier die Möglichkeit zur Verfügung, die Bitreihe über Leitung 7 dem UND-Glied A1 zuzuführen, um es über den Anschluß DATENAUSGABE abzugeben.

Durch geeignet gewählte Taktsignale kann die sequentielle Reihenfolge der am Anschluß DATENAUSGABE abgegebenen Bits ohne weiteres so gewählt werden, daß die Bits des ersten Datenelements in ihrer ursprünglichen Reihenfolge (Fig. 11) und die Bits des zweiten Datenelements ebenfalls in ihrer ursprünglichen Reihenfolge (Fig. 12) erscheinen. Die mit Bezugszeichen L1 symbolisch angedeuteten Logikschaltungen für Adreßdecodierer, ungerade/gerade Zeitsteuerung und SCHLEIFEN-Selektor liefern geeignete Zeitsignale an die UND-Glieder A1, A2, mit denen die E/A-Schnittstelle bei L2 im geeigneten Augenblick getaktet wird und die Bits der betreffenden Datenelemente in deren ursprünglichen Reihenfolge entsprechend den Figuren 11 oder 12 abgibt oder in einer anderen willkürlichen Reihenfolge.

FI 978 006

0006467

P A T E N T A N S P R Ü C H E

1. Ladungstransportspeicher mit CCD-Schleifen vom Typ seriell-parallel-seriell (SPS), dadurch gekennzeichnet, daß mindestens ein Paar Schleifen (SCHLEIFE 1, SCHLEIFE 2; Fig. 7) vorgesehen ist und daß jede Zeile des Parallelabschnitts (P1) der ersten Schleife eines Paars abwechselnd die ungeradzahligen Bits (A1, A3, A5, ....) eines ersten Datenelements A und die geradzahligen Bits (B2, B4, B6, ....) eines zweiten Datenelements B in der Form A1 B2 A3 B4 A5 B6 .... aufnimmt und daß jede Zeile des Parallelabschnitts (P2) der zweiten Schleife die geradzahligen Bits des ersten Datenelements und die ungeradzahligen Bits des zweiten Datenelements in der Form B1 A2 B3 A 4 B5 A6 .... aufnimmt.

2. Ladungstransportspeicher nach Anspruch 1, dadurch gekennzeichnet, daß eine Adreßdecodier- und Zeitsteuerschaltung (L1) vorgesehen ist, die Steuersignale zum Mischen der Bits zweier seriell eintreffender Datenelemente in der ersten Zeile des Parallelabschnitts der SPS-Schleifen liefert sowie Steuersignale zum Entmischen der in den Ausgangsschieberegistern (SO1, SOL) der SPS-Schleifen enthaltenen verschränkten Daten in die ursprüngliche Bitreihenfolge.

3. Ladungstransportspeicher nach Anspruch 1 oder 2, dadurch gekennzeichnet, daß die Eingangsschieberegister (SI1, SI2, SIN) über UND-Glieder (A11, A12, A1N) an die Dateneingangsleitung angeschlossen sind und die Ausgangsschieberegister (SO1, SO2, SON) über UND-Glieder (A31, A32, A3N) an die Datenausgangsleitung und daß die UND-Glieder an weiteren Eingängen Zeitsteuersignale empfangen.

FI 978 006

4. Ladungstransportspeicher nach einem der Ansprüche 1 bis 3, dadurch gekennzeichnet, daß die letzte Zeile des Parallelabschnitts einer SPS-Schleife parallel in das Ausgangsschieberegister SO übertragen wird.

5. Ladungstransportspeicher nach einem der Ansprüche 1 bis 4, dadurch gekennzeichnet, daß als Datenelement ein Byte gewählt ist.

FI 978 006

## FIG. 1  STAND DER TECHNIK

## FIG. 4  STAND DER TECHNIK

## FIG. 2  STAND DER TECHNIK

## FIG. 5  STAND DER TECHNIK

## FIG. 3  STAND DER TECHNIK

## FIG. 6  STAND DER TECHNIK

FIG.7

FIG.7

0006467

FIG. 8

0006467

```
ØXE  ─────────────────────────────
ØAO  ─────────────────────
Ø11  ───────
        ┌──┬──┬──┬──┬──┬──┬──┬──┐
        │X8│A7│X6│A5│X4│A3│X2│A1│
        └──┴──┴──┴──┴──┴──┴──┴──┘
```

## FIG.9

```
ØAE  ─────────────────────────────
ØXO  ─────────────────────
Ø12  ───────
        ┌──┬──┬──┬──┬──┬──┬──┬──┐
        │A8│X7│A6│X5│A4│X3│A2│X1│
        └──┴──┴──┴──┴──┴──┴──┴──┘
```

## FIG.10

```
┌──┬──┬──┬──┬──┬──┬──┬──┐
│A8│A7│A6│A5│A4│A3│A2│A1│
└──┴──┴──┴──┴──┴──┴──┴──┘
```

## FIG.11

```
┌──┬──┬──┬──┬──┬──┬──┬──┐
│X8│X7│X6│X5│X4│X3│X2│X1│
└──┴──┴──┴──┴──┴──┴──┴──┘
```

## FIG.12